# EUROPÄISCHE PATENTANMELDUNG

(11) **EP 2 426 676 A1**
(43) Veröffentlichungstag der Anmeldung: **07.03.2012**
(21) Anmeldenummer: 10305941.6
(22) Anmeldetag: 02.09.2010
(51) Int. Cl.: H01B 12/02

(54) **Anordnung mit mindestens einem supraleitfähigen Kabel**

(71) Anmelder: Nexans, 75008 Paris (FR)
(72) Erfinder: Dr. Soika, Rainer, 30559, Hannover (DE); Dr. West, Beate, 30163, Hannover (DE); Dr.-Ing. Stemmle, Mark, 30161, Hannover (DE)
(74) Vertreter: Döring, Roger

(57) **Zusammenfassung**

Es wird eine Anordnung mit mindestens einem supraleitfähigen Kabel (1) angegeben, das in einem zur Führung eines Kühlmittels dienenden Kryostat (KR) angeordnet ist, welcher mindestens ein thermisch isoliertes metallisches Rohr aufweist. Außen auf dem Kryostat (KR) ist elektrisch gut leitendes Material angebracht, das aus mindestens zwei Strängen (6,7) besteht, die in zwei mit entgegengesetzter Schlagrichtung übereinander angebrachten Lagen um den Kryostat (KR) herum gewickelt sind. Die Stränge (6,7) sind an in axialen Abständen angebrachten Festpunkten (8) fest und unverrückbar mit dem Kryostat (KR) verbunden.

## Beschreibung

Anordnung mit mindestens einem supraleitfähigen Kabel, das in einem zur Führung eines Kühlmittels dienenden Kryostat angeordnet ist, welcher mindestens ein thermisch isoliertes metallisches Rohr aufweist, bei welcher außen auf dem Kryostat elektrisch gut leitendes Material angebracht ist, das am Kryostat anliegt (EP 2 071 589 A1).

Ein supraleitfähiges Kabel hat mindestens einen elektrischen Leiter aus einem speziellen Material, das bei ausreichend tiefen Temperaturen in den supraleitfähigen Zustand übergeht. Der Gleichstromwiderstand des Leiters ist dann gleich Null. Geeignete Materialien sind beispielsweise YBCO (Yttrium-Barium-Kupfer-Oxid) oder BiSCCO (Wismut-Strontium-Kalzium-Kupfer-Oxid). Ausreichend niedrige Temperaturen für ein derartiges Material betragen beispielsweise zwischen 4 K und 110 K, um den supraleitfähigen Zustand zu erreichen. Geeignete Kühlmittel sind beispielsweise Stickstoff, Helium, Neon und Wasserstoff oder Gemische dieser Stoffe, jeweils in gasförmigem oder flüssigem Zustand. Es sind supraleitfähige Kabel mit kaltem Dielektrikum und mit warmem Dielektrikum bekannt.

Bei einem supraleitfähigen Kabel mit kaltem Dielektrikum ist der supraleitfähige Leiter von einem aus Schichten aus Isoliermaterial bestehenden Dielektrikum umgeben, bei dem ein flüssiges Kühlmedium als Imprägniermittel im Dielektrikum (Isolierung) vorhanden ist. Ein solches Kabel besteht beispielsweise aus dem Leiter als Innenleiter und einem konzentrisch dazu angeordneten Schirm bzw. Rückleiter, die durch das Dielektrikum voneinander getrennt und auf Abstand gehalten sind. Ein entsprechendes Kabel ist von einem ein Kühlmittel führenden Kryostat umgeben, der beispielsweise aus zwei konzentrischen, durch eine thermische Isolierung gegeneinander isolierten, metallischen Rohren besteht.

Supraleitfähige Kabel mit warmem Dielektrikum haben einen Leiter, der direkt in einem das Kühlmittel führenden Kryostat angeordnet ist. Dielektrikum und Schirm bzw. Rückleiter sind hier außerhalb des Kryostats unter Anlage an demselben angebracht.

Bei allen bekannten Anordnungen mit supraleitfähigen Kabeln, egal ob mit kaltem oder warmem Dielektrikum, müssen die elektrischen Leiter so bemessen sein, daß der Energieeintrag im Falle eines Kurzschlusses nicht zur Zerstörung der Kabel und/oder zu einer unzulässigen Erwärmung führt. Das bedingt einen ausreichend großen elektrisch leitenden Querschnitt der Leiter mit entsprechend großen Abmessungen der jeweiligen Anordnung. Hinzu kommt, daß eine solche aus Kryostat und umschlossenem supraleitfähigen Kabel bestehende Anordnung zu ihrem Betrieb in einen Kabelkanal eingezogen werden muß. Dazu wird außen am Kryostat ein Ziehmechanismus befestigt, durch welchen die Abmessungen der Anordnung weiter vergrößert werden. Auch die lichte Weite des Kabelkanals muß an diese relativ großen Abmessungen angepaßt werden.

Bei der bekannten Anordnung nach der eingangs erwähnten EP 2 071 589 A1 liegt ein aus elektrisch gut leitendem Material bestehender Normalleiter, der mit einem von einem Kryostat umgebenen supraleitfähigen Kabel verbunden ist, außen an dem Kryostat an. Der Normalleiter befindet sich damit auf Raumtemperatur und somit insbesondere außerhalb des bei Betrieb des Kabels wirksamen Kühlbereichs. Im Kurzschlußfall eingebrachte Energie belastet bei dieser Anordnung das Kühlsystem innerhalb des Kryostats nicht. Auch diese aus Kabel und Kryostat bestehende Anordnung wird bei ihrer Verlegung in einen Kabelkanal eingezogen. Dazu wird in bekannter Technik der bereits erwähnte aufwendige Ziehmechanismus außen am Kryostat angebracht. Die Außenabmessungen dieser Anordnung sind dementsprechend relativ groß.

Der Erfindung liegt die Aufgabe zugrunde, die eingangs geschilderte Anordnung so zu gestalten, daß ihre radialen Abmessungen verkleinert werden können.

Diese Aufgabe wird gemäß der Erfindung dadurch gelöst,
- daß das elektrisch gut leitende Material aus mindestens zwei Strängen besteht, die in zwei mit entgegengesetzter Schlagrichtung übereinander angebrachten Lagen um den Kryostat herum gewickelt sind, und
- daß die Stränge an in axialen Abständen angebrachten Festpunkten fest und unverrückbar rundum mit dem Kryostat verbunden sind.

Die radialen Abmessungen des supraleitfähigen Kabels dieser Anordnung können vermindert werden, weil kein dasselbe direkt umgebender, normalleitender Schirm vorhanden ist. Dessen Funktion übernehmen die außerhalb des Kryostats unter Anlage an demselben angeordneten Stränge, die in mindestens zwei Lagen mit entsprechendem elektrisch leitendem Querschnitt aufgebracht sind. Sie können daher auch einen erhöhten Kurzschlußstrom führen, belasten das Kühlsystem des supraleitfähigen Kabels wegen ihrer Anordnung außerhalb des Kryostats aber nicht. Wegen der verminderten Abmessungen des supraleitfähigen Kabels können auch die Abmessungen des Kryostats verkleinert werden. Da die Stränge in axialen Abständen umlaufend fest mit dem Kryostat verbunden sind, ist die Zugfestigkeit desselben bzw. der ganzen Anordnung wesentlich erhöht, wobei die Stränge selbst auch als Zugelemente wirken. Die ganze Anordnung kann daher beispielsweise mit einem einfachen Zugseil oder einem Ziehstrumpf, die beide in radialer Richtung nicht wesentlich auftragen, in einen Kabelkanal eingezogen werden. Der Kabelkanal kann daher ebenfalls eine reduzierte lichte Weite haben. Zugseil oder Ziehstrumpf werden zum Einziehen der Anordnung in einen Kabelkanal, und zwar auch bei einer größeren Länge derselben, am Anfangsende der Anordnung montiert. Sie können abschließend wieder entfernt werden.

Ein Ausführungsbeispiel des Erfindungsgegenstandes ist in der Zeichnung dargestellt.

Es zeigen:
Fig. 1 einen Querschnitt der Anordnung nach der Erfindung.
Fig. 2 eine Seitenansicht der Anordnung nach Fig. 1 mit teilweise entfernten Schichten.

Die Stränge aus elektrisch gut leitendem Material können aus Kupfer oder Aluminium oder Legierungen dieser Materialien bestehen. Sie werden im folgenden - stellvertretend für alle möglichen Ausführungsformen - als "Kupferstränge" bezeichnet.

Das in der Anordnung nach der Erfindung eingesetzte supraleitfähige Kabel ist mit Vorteil als Kabel mit kaltem Dielektrikum ausgeführt. Es wird im folgenden der Einfachheit halber nur als "Kabel" bezeichnet. Der das Kabel umgebende Kryostat weist mindestens ein thermisch isoliertes, metallisches Rohr auf. Er besteht im geschilderten Ausführungsbeispiel aus zwei konzentrisch zueinander angeordneten metallischen Rohren, zwischen denen eine thermische Isolierung angebracht ist. Die Rohre können quer zu ihrer Längsrichtung gewellt sein. In dem Kryostat kann auch mehr als ein Kabel untergebracht sein.

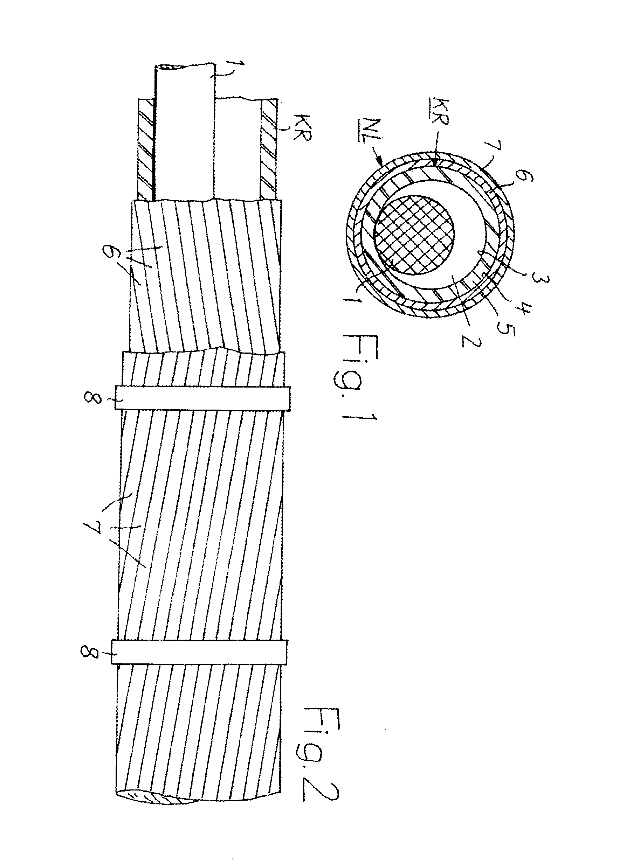

Das in Fig. 1 dargestellte Kabel ist als einphasiges Kabel mit kaltem Dielektrikum ausgeführt. Es hat eine Kabelseele 1, in der ein im Betrieb auf Hochspannungspotential liegender Innenleiter aus supraleitfähigem Material angeordnet ist, der zumindest von einem Dielektrikum umgeben ist. Die Kabelseele 1 ist unter Einschluß eines durchgehenden Freiraums 2 in einem Kryostat KR angeordnet ist. Der Kryostat KR besteht - wie bereits erwähnt - aus zwei konzentrischen metallischen Rohren 3 und 4, die durch einen Ringraum 5 voneinander getrennt sind, in dem sich eine thermische Isolierung befindet. Durch den Kryostat KR wird zur Kühlung des supraleitfähigen Leiters des Kabels ein Kühlmittel geleitet, beispielsweise flüssiger Stickstoff. Außerhalb des Kryostats KR ist ein Normalleiter NL angeordnet, der am Kryostat KR bzw. an dessen äußerem Rohr 4 anliegt. Er ist mit dem Kryostat KR elektrisch leitend verbunden, so daß diese Teile auf gleichem elektrischem Potential liegen.

Der Normalleiter NL besteht aus mindestens zwei Kupfersträngen 6 und 7, die in zwei Lagen übereinanderliegend um den Kryostat KR herumgewickelt sind, und zwar mit entgegengesetzter Schlagrichtung. Die Schlaglänge der beiden Kupferstränge 6 und 7 ist mit Vorteil gleich. Die Kupferstränge 6 und 7 können als Runddrähte, als Bänder oder in bevorzugter Ausführungsform als Leiterprofile ausgeführt sein. Aus mechanischen Gründen werden sie mit einer möglichst großen Schlaglänge um den Kryostat KR herumgewickelt, damit sie ohne wesentliche Belastung in Umfangsrichtung des Kryostats KR Zugkräfte aufnehmen können, die in Achsrichtung des Kryostats KR aufgebracht werden. Hierbei können aber auch Gesichtspunkte der Stromverteilung zu berücksichtigen sein. Um einen möglicherweise signifikanten Strom im Normalbetrieb zu vermeiden, kann die Schlaglänge der beiden Kupferstränge 6 und 7 auch kürzer ausgeführt werden, als die aus mechanischen Gründen vorgesehene, ideale Schlaglänge.

Es sind mindestens zwei Kupferstränge 6 und 7 für den Normalleiter NL vorhanden, damit bei einer Zugbelastung der Anordnung keine Torsion auf dieselbe ausgeübt wird. Es können auch mehr als zwei Lagen von Kupfersträngen aufgebracht werden, deren Anzahl stets ein Vielfaches von "2" ist.

Die Kupferstränge 6 und 7 sind in axialen Abständen an Festpunkten 8 umlaufend fest mit dem Kryostat KR verbunden, dessen Stabilität in Achsrichtung dadurch so weit erhöht ist, daß auf denselben ausgeübte Zugkräfte direkt und ohne unerwünschte Längung des Kryostats KR in axialer Richtung aufgenommen werden können. Die Festpunkte 8 können beispielsweise durch Bandagen oder Manschetten erzeugt werden, die mit ausreichendem Festsitz rund um die den Kryostat KR umgebenden und an demselben anliegenden Kupferstränge 6 und 7 herumgelegt werden.

## Patentansprüche

1. Anordnung mit mindestens einem supraleitfähigen Kabel, das in einem zur Führung eines Kühlmittels dienenden Kryostat angeordnet ist, welcher mindestens ein thermisch isoliertes metallisches Rohr aufweist, bei welcher außen auf dem Kryostat elektrisch gut leitendes Material angebracht ist, das am Kryostat anliegt, **dadurch gekennzeichnet,**
- **daß** das elektrisch gut leitende Material aus mindestens zwei Strängen (6,7) besteht, die in zwei mit entgegengesetzter Schlagrichtung übereinander angebrachten Lagen um den Kryostat (KR) herum gewickelt sind, und
- **daß** die Stränge (6,7) an in axialen Abständen angebrachten Festpunkten (8) fest und unverrückbar mit dem Kryostat (KR) verbunden sind.

2. Anordnung nach Anspruch 1, **dadurch gekennzeichnet, daß** an den Festpunkten (8) jeweils eine Bandage oder Manschette um die den Kryostat (KR) rundum umgebenden Stränge (6,7) herumgelegt ist.
